# EUROPÄISCHE PATENTSCHRIFT

(11) **EP 4 300 124 B1**
(45) Veröffentlichungstag und Bekanntmachung des Hinweises auf die Patenterteilung: **19.11.2025**
(21) Anmeldenummer: 22181850.3
(22) Anmeldetag: 29.06.2022
(51) Int. Cl.: G01R 33/421, G01R 33/385, G01R 33/3815

(54) **MAGNETEINHEIT ZUR VERWENDUNG IN EINEM MAGNETRESONANZGERÄT IN KOMBINATION MIT EINER GRADIENTENSPULENEINHEIT FREI VON AKTIVER SCHIRMUNG**
MAGNETIC UNIT FOR USE IN A MAGNETIC RESONANCE DEVICE IN COMBINATION WITH A GRADIENT COIL UNIT FREE OF ACTIVE SHIELDING
UNITÉ D'AIMANT DESTINÉE À ÊTRE UTILISÉE DANS UN APPAREIL DE RÉSONANCE MAGNÉTIQUE EN COMBINAISON AVEC UNE UNITÉ DE BOBINE DE GRADIENT SANS BLINDAGE ACTIF

(43) Veröffentlichungstag der Anmeldung: 03.01.2024
(73) Patentinhaber: Siemens Healthineers AG, 91301 Forchheim (DE)
(72) Erfinder: Biber, Stephan, 91056 Erlangen (DE); Dietz, Peter, 90762 Fürth (DE)
(74) Vertreter: Siemens Healthineers Patent Attorneys

(56) Entgegenhaltungen:
- WO-A1-2016/114198
- US-A1- 2014 210 476
- US-A1- 2021 223 339

## Beschreibung

Die Erfindung betrifft eine Magneteinheit zur Verwendung in einem Magnetresonanzgerät sowie ein Magnetresonanzgerät umfassend eine solche Magneteinheit.

In einem Magnetresonanzgerät wird üblicherweise der zu untersuchende Körper eines Untersuchungsobjektes, insbesondere eines Patienten, mit Hilfe eines Hauptmagneten, insbesondere einer Magneteinheit, einem relativ hohen Hauptmagnetfeld, beispielsweise von 0,55 oder 1,5 oder 3 oder 7 Tesla, ausgesetzt. Zusätzlich werden mit Hilfe einer Gradientenspuleneinheit Gradientenpulse ausgespielt. Über eine Hochfrequenzantenneneinheit werden dann mittels geeigneter Antenneneinrichtungen hochfrequente Hochfrequenz-Pulse, beispielsweise Anregungspulse, ausgesendet, was dazu führt, dass die Kernspins bestimmter, durch diese Hochfrequenz-Pulse resonant angeregter Atome um einen definierten Flipwinkel gegenüber den Magnetfeldlinien des Hauptmagnetfelds verkippt werden. Bei der Relaxation der Kernspins werden Hochfrequenz-Signale, so genannte Magnetresonanz-Signale, abgestrahlt, die mittels geeigneter Hochfrequenzantennen empfangen und dann weiterverarbeitet werden. Aus den so akquirierten Rohdaten können schließlich die gewünschten Bilddaten rekonstruiert werden.

Eine Gradientenspuleneinheit umfasst herkömmlich drei Primärspulen und drei dazu korrespondierende Sekundärspulen. Die drei Primärspulen werden typischerweise von einer Primärspuleneinheit umfasst. Die drei Sekundärspulen werden typischerweise von einer Sekundärspuleneinheit umfasst. Eine Primärspule ist typischerweise zur Erzeugung eines Magnetfeldgradienten in eine Raumrichtung ausgelegt. Ein Magnetfeldgradient ist typischerweise ein Magnetfeld erster Ordnung und/oder linearer Ordnung, insbesondere ein Magnetfeld, dessen Amplitude entlang einer Raumrichtung linear ansteigt. Bei der Ansteuerung einer Primärspule werden Streufelder außerhalb der Gradientenspuleneinheit erzeugt, welche mit den die Gradientenspuleneinheit umgebenden leitfähigen Strukturen interagieren, wobei Wirbelströme entstehen. Diese Wirbelströme erzeugen ihrerseits Ohm'sche Wärme, welche ein Quenchen einer von der Magneteinheit umfassten supraleitenden Spuleneinheit bewirken kann. Zusätzlich erzeugen die Wirbelströme ihrerseits ein Magnetfeld, ein sogenanntes Wirbelfeld, welches die Qualität von Bilddaten negativ beeinflussen kann.

Herkömmlich werden die Streufelder und Wirbelströme durch Sekundärspulen unterdrückt, wobei jeweils einer Primärspule eine korrespondierende Sekundärspule zugeordnet ist. Erzeugt die Primärspule ein Streufeld, so ist die der Primärspule korrespondierende Sekundärspule dazu ausgebildet, ein dem Streufeld entgegengerichtetes Magnetfeld zu erzeugen, welches insbesondere außerhalb des Patientenaufnahmebereiches wirkt. Hierfür weist die Sekundärspule herkömmlich eine zur ersten Primärspule ähnliche Leiterstruktur auf, welche analog zur Primärspule mit invertiertem Vorzeichen wie die Primärspule angesteuert wird und dadurch überwiegend ein Magnetfeld erster Ordnung erzeugt, welches dem von der Primärspule erzeugten Magnetfeldgradienten entgegengerichtet ist. Außerhalb des Patientenaufnahmebereiches überlagern sich die von der Primärspule und der Sekundärspule erzeugten Magnetfelder typischerweise destruktiv. Herkömmlich umfasst eine Gradientenspuleneinheit typischerweise eine Sekundärspuleneinheit umfassend drei Sekundärspulen, wobei jeweils einer Primärspule eine Sekundärspule zugeordnet ist. Die Primärspulen und die Sekundärspulen werden herkömmlich mit elektrischen Strömen gesteuert, deren Amplituden bis zu 1 kA erreichen und die häufigen und raschen Wechseln der Stromrichtung mit Anstiegs- und Abfallraten von mehreren 100 kA/s unterliegen. Die treibende Spannung für den Spulenstrom beträgt bis zu mehreren kV.

Die Sekundärspulen benötigen dabei Raum, sodass eine Gradientenspuleneinheit mit Sekundärspulen einen geringeren Innendurchmesser hat als eine Gradientenspuleneinheit ohne Sekundärspulen, wodurch der Patientenaufnahmebereich enger wird. Zusätzlich benötigt die aktive Schirmung, also die Ansteuerung der Sekundärspuleneinheit, viel Energie, welche in Form von Strom und Spannung durch Gradientenverstärker bereitgestellt werden muss. Gradientenspuleneinheiten ohne Sekundärspulen sind folglich hinsichtlich der Größe des Patientenaufnahmebereiches und des Energieverbrauches vorteilhaft, sofern die Wirbelströme betreffend die Magneteinheit und/oder supraleitende Spuleneinheit und/oder dadurch entstehende und im Patientenaufnahmebereich wirkende Wirbelfelder kompensiert werden können.

US 2021/223339 A1 offenbart ein Magnetresonanzgerät mit einem Kryostat aufweisend eine supraleitfähige Spuleneinheit und eine leitfähige Schirmeinheit. WO 2016/114198 A1 offenbart ein Magnetresonanzgerät, bei dem zwischen der Gradientenspuleneinheit und dem Hauptmagneten Ringstrukturen mit unterschiedlichen Leitfähigkeiten angeordnet sind. US 2014/210476 A1 offenbart ein Magnetresonanzgerät, bei dem zwischen der Gradientenspuleneinheit und dem Hauptmagneten leitfähige Ringstrukturen angeordnet sind.

Der Erfindung liegt die Aufgabe zugrunde, eine besonders robuste Magneteinheit mit intrinsischer Schirmung gegen von der Gradientenspuleneinheit erzeugte Streufelder und/oder Wirbelströme anzugeben. Die Aufgabe wird durch die Merkmale der unabhängigen Ansprüche gelöst. Vorteilhafte Ausgestaltungen sind in den Unteransprüchen beschrieben.

Die erfindungsgemäße Magneteinheit gemäß Anspruch 1, welche zur Verwendung in einem Magnetresonanzgerät ausgebildet ist, umfasst einen hohlzylindrischen Vakuumbehälter umgebend einen zylindrischen Patientenaufnahmebereich entlang einer Zylinderachse in Längsrichtung. Die Magneteinheit umfasst eine supraleitende Spuleneinheit, welche zur Erzeugung eines statischen Hauptmagnetfeldes ausgebildet und innerhalb des hohlzylindrischen Vakuumbehälters angeordnet ist. Zusätzlich umfasst die Magneteinheit eine passive Abschirmeinheit umfassend eine Trägerstruktureinheit, welche hohlzylinderförmig den Patientenaufnahmebereich umgibt, und zumindest zwei Ringstrukturen, welche hohlzylinderförmig ausgebildet sind, wobei die zumindest zwei Ringstrukturen senkrecht zur radialen Richtung flächigen Kontakt zu der Trägerstruktureinheit aufweisen und zwei der zumindest zwei Ringstrukturen in Längsrichtung zueinander beabstandet sind.

Die passive Abschirmeinheit ist typischerweise zwischen Patientenaufnahmebereich und supraleitender Spuleneinheit angeordnet. Die supraleitende Spuleneinheit ist typischerweise innerhalb des hohlzylindrischen Vakuumbehälters angeordnet, innerhalb welchen eine Temperatur von weniger als 100 K vorherrscht. Insbesondere der Bereich, in welchem die supraleitende Spuleneinheit angeordnet ist, weist typischerweise eine Temperatur von höchstens 10 K auf. Die Zylinderachse des hohlzylindrischen Vakuumbehälters entspricht typischerweise der Zylinderachse des zylindrischen Patientenaufnahmebereichs und/oder der Magneteinheit und/oder der passiven Abschirmeinheit und/oder der Trägerstruktureinheit und/oder der supraleitenden Spuleneinheit. Die Magneteinheit kann zudem eine thermische Abschirmeinheit umfassen.

Die zumindest zwei Ringstrukturen weisen in Längsrichtung typischerweise einzeln und/oder insgesamt eine kürzere räumliche Ausdehnung auf als die Trägerstruktureinheit. Der Außenradius der Trägerstruktureinheit kann dem Innenradius zumindest einer Ringstruktur der zumindest zwei Ringstrukturen entsprechen. Der Innenradius der Trägerstruktureinheit kann dem Außenradius zumindest einer Ringstruktur der zumindest zwei Ringstrukturen entsprechen. Der flächige Kontakt zwischen der Trägerstruktureinheit und den zumindest zwei Ringstrukturen liegt vorzugsweise in tangentialer Richtung und in Längsrichtung vor. Eine Fixierung von der Trägerstruktureinheit und den zumindest zwei Ringstrukturen kann durch passgenaue Formung und/oder passgenaue Anordnung und/oder durch mechanische Kopplung und/oder durch Klebung erfolgen. Die zumindest zwei Ringstrukturen weisen in Längsrichtung zueinander typischerweise einen Abstand von zumindest 2 cm, bevorzugt von zumindest 5 cm, besonders bevorzugt von zumindest 10 cm auf. Die zumindest zwei Ringstrukturen werden durch die Trägerstruktureinheit typischerweise stabilisiert und an fixen Positionen gehalten.

Die zumindest zwei Ringstrukturen sind typischerweise relativ zur Trägerstruktureinheit als Erhöhungen in radialer Richtung, insbesondere als Überstand relativ zur Trägerstruktureinheit ausgebildet. Dadurch ist die passive Abschirmeinheit besonders steif, insbesondere robust und/oder leicht herzustellen. Zudem beeinflusst typischerweise die geometrische Anordnung der Ringstrukturen die Amplitude und/oder Richtung der Wirbelströme auf den Ringstrukturen, welche aufgrund eines bei Ansteuerung der Gradientenspuleneinheit, welche keine Sekundärspuleneinheit umfasst, entstehenden Streufeldes entstehen. Die passive Abschirmeinheit, und insbesondere die Ringstrukturen, bilden demnach typischerweise eine Barriere zwischen der Gradientenspuleneinheit und der supraleitenden Spuleneinheit. Insbesondere ist die passive Abschirmeinheit, und insbesondere die Ringstrukturen, vorzugweise derart ausgestaltet, dass die supraleitende Spuleneinheit vor dem Streufeld abgeschirmt wird. Die zumindest zwei Ringstrukturen können auch derart ausgestaltet sein, dass sich auf den zumindest zwei Ringstrukturen Wirbelströme derart ausbilden, dass die durch diese Wirbelströme entstehenden Wirbelfelder den auf anderen leitfähigen Strukturen entstehenden Wirbelfeldern entgegengerichtet sind und diese zumindest teilweise kompensieren. Insbesondere kann durch eine derartige Kompensation das Streufeld vor dem Erreichen der supraleitenden Spuleneinheit effizient reduziert werden. Folglich kann durch eine Änderung der geometrischen Anordnung der Ringstrukturen, welche vorzugsweise flexibel vorgenommen werden kann, das Maß der Abschirmung individuell bestimmt und/oder angepasst werden.

Die passive Abschirmeinheit weist durch eine separate Verwendung der Trägerstruktureinheit und den zumindest zwei Ringstrukturen zudem eine besondere Steifheit auf, wodurch resonante Schwingungen der passiven Abschirmeinheit reduziert und/oder unterdrückt werden. Dadurch kann die Entstehung von Wirbelströmen aufgrund der resonanten Schwingungen und/oder dadurch entstehende Wärme gerichtet auf die supraleitende Spuleneinheit und/oder ein thermisches Schild unterbunden werden. Ebenso wird die Entstehung eines Wirbelfeldes reduziert, was eine Qualität von mit dem Magnetresonanzgerät aufzunehmenden Bilddaten positiv beeinflusst. Die erfindungsgemäße Magneteinheit weist demnach mit der passiven Abschirmeinheit eine intrinsische Schirmung gegen von der Gradientenspuleneinheit erzeugte Streufelder und/oder Wirbelströme auf.

Eine Ausführungsform der Magneteinheit sieht vor, dass die räumliche Ausdehnung in Längsrichtung der Trägerstruktureinheit zumindest viermal so groß wie die räumliche Ausdehnung in Längsrichtung einer Ringstruktur der zumindest zwei Ringstrukturen ist. Dies ermöglicht eine robuste Befestigung der zumindest zwei Ringstrukturen an der Trägerstruktureinheit und reduziert Schwingungsmoden, welche wiederum selbst Wirbelströme erzeugen können.

Eine Ausführungsform der Magneteinheit sieht vor, dass die zumindest zwei Ringstrukturen eine elektrische Leitfähigkeit von zumindest 2 x 10⁷ S/m aufweisen und die Trägerstruktureinheit eine elektrische Leitfähigkeit von weniger als 10⁵ S/m aufweist. Die zumindest zwei Ringstrukturen weisen typischerweise eine elektrische Leitfähigkeit von zumindest 2 x 10⁷ S/m, bevorzugt von zumindest 5 x 10⁷ S/m, besonders bevorzugt von zumindest 50 x 10⁷ S/m auf. Die Trägerstruktureinheit weist typischerweise eine elektrische Leitfähigkeit von höchstens 10⁵ S/m, bevorzugt von höchstens 10⁴ S/m, besonders bevorzugt von höchstens 5 x 10³ S/m auf. Die Trägerstruktureinheit umfasst demnach typischerweise elektrisch isolierendes Material. Die zumindest zwei Ringstrukturen umfassen demnach typischerweise elektrisch stark leitfähiges Material.

Diese Ausführungsform ermöglicht, dass sich Wirbelströme auf den zumindest zwei Ringstrukturen ausbilden, welche zumindest zwei Ringstrukturen durch die Trägerstruktureinheit stabilisiert und an fixen Positionen gehalten werden, wobei sich die Wirbelströme nicht auf die Trägerstruktureinheit mit geringerer Leitfähigkeit übertragen können. Insbesondere verhindert eine derartige Trägerstruktureinheit ein Ausbilden von Wirbelströmen mit Zeitkonstanten von größer als 0,5 ms, insbesondere von 0,1 ms, was geringer ist als eine Zeitkonstante des Kryostaten.

Eine Ausführungsform der Magneteinheit sieht vor, dass die Trägerstruktureinheit zumindest eines der folgenden Materialien umfasst: Faser-Kunststoff-Verbund, glasfaserverstärkter Kunststoff, kohlenstofffaserverstärkter Kunststoff. Derartige Materialien sind besonders steif und robust, wodurch die passive Abschirmeinheit besonders geringen Schwingungen ausgesetzt ist und Wirbelströme besonders gut vermeidet. Des Weiteren sind derartige Materialien nichtleitend, wodurch eine Bildung von Wirbelströmen auf der Trägerstruktureinheit verhindert wird.

Eine Ausführungsform der Magneteinheit sieht vor, dass die Trägerstruktureinheit als Gerüststruktur oder als massiver Hohlzylinder ausgebildet ist. Sofern die Trägerstruktureinheit als massiver Hohlzylinder ausgebildet ist, ist diese besonders robust und leicht zu fertigen. Ist die Trägerstruktureinheit als Gerüststruktur ausgebildet, so kann diese beispielsweise die Form eines Birdcages annehmen. Dies ermöglicht reduzierten Materialeinsatz.

Eine Ausführungsform der Magneteinheit sieht vor, dass die Trägerstruktureinheit zumindest zwei in Längsrichtung beabstandete Hohlzylinder angeordnet um die Zylinderachse umfasst. Die in Längsrichtung zueinander beabstandeten Hohlzylinder weisen vorzugsweise den gleichen Innenradius und/oder Außenradius auf und/oder sind symmetrisch zum Isozentrum der Magneteinheit angeordnet. Das Isozentrum entspricht typischerweise dem räumlichen Mittelpunkt des zylindrischen Patientenaufnahmebereichs. Diese Ausführungsform verhindert, dass Vibrationsmoden und/oder Schwingungsmoden über die gesamte Trägerstruktureinheit und/oder passive Abschirmeinheit entstehen und ermöglicht demnach eine robuste Verwendung.

Eine Ausführungsform der Magneteinheit sieht vor, dass die zumindest zwei Ringstrukturen eine voneinander verschiedene Wanddicke und/oder räumliche Ausdehnung in Längsrichtung aufweisen. Die Wanddicke einer Ringstruktur und/oder der Trägerstruktureinheit, insbesondere eines Hohlzylinders, ist typischerweise durch die Differenz zwischen Außenradius und Innenradius bestimmt. Diese Ausführungsform ermöglicht eine besonders effiziente und individuelle Steuerung entstehender Wirbelströme und deren Verteilung, insbesondere im Bereich der zumindest zwei Ringstrukturen und der supraleitenden Spuleneinheit.

Eine Ringstruktur der zumindest zwei Ringstrukturen weist typischerweise eine räumliche Ausdehnung in Längsrichtung von zumindest 1 cm, bevorzugt von zumindest 2 cm, besonders bevorzugt von zumindest 5 cm auf. Eine Ringstruktur der zumindest zwei Ringstrukturen weist typischerweise eine räumliche Ausdehnung in Längsrichtung von höchstens 40 cm, bevorzugt von höchstens 35 cm, besonders bevorzugt von höchstens 30 cm auf. Eine Ringstruktur der zumindest zwei Ringstrukturen weist typischerweise eine Wanddicke von zumindest 0,5 cm, bevorzugt von zumindest 2 cm, besonders bevorzugt von zumindest 4 cm auf. Eine Ringstruktur der zumindest zwei Ringstrukturen weist typischerweise eine Wanddicke von höchstens 12 **cm,** bevorzugt von höchstens 8 cm**,** besonders bevorzugt von höchstens 6 cm auf**.**

Die Trägerstruktureinheit weist typischerweise eine räumliche Ausdehnung in Längsrichtung von zumindest 120 **cm,** bevorzugt von zumindest 140 **cm,** besonders bevorzugt von zumindest 160 cm auf**.** Die Trägerstruktureinheit weist typischerweise eine räumliche Ausdehnung in Längsrichtung von höchstens 200 cm, bevorzugt von höchstens 190 **cm,** besonders bevorzugt von höchstens 170 cm auf**.** Die Trägerstruktureinheit weist typischerweise eine Wanddicke von zumindest 1 **cm,** bevorzugt von zumindest 4 cm, besonders bevorzugt von zumindest 8 cm auf. Die Trägerstruktureinheit weist typischerweise eine Wanddicke von höchstens 20 cm, bevorzugt von höchstens 15 cm, besonders bevorzugt von höchstens 12 cm auf**.**

Die Trägerstruktureinheit ist typischerweise als Hohlzylinder mit einem inneren Durchmesser von zumindest 65 cm, bevorzugt von zumindest 80 **cm,** besonders bevorzugt von zumindest 95 cm ausgebildet. Die Trägerstruktureinheit ist typischerweise als Hohlzylinder mit einem inneren Durchmesser von höchstens 130 cm, bevorzugt von zumindest 120 cm, besonders bevorzugt von zumindest 110 cm ausgebildet.

Erfindungsgemäß variiert die räumliche Ausdehnung in Längsrichtung und/oder in radialer Richtung zumindest einer Ringstruktur der zumindest zwei Ringstrukturen in Umfangsrichtung. Insbesondere kann eine Ringstruktur eine beliebige Kontur, insbesondere senkrecht zur radialen und senkrecht zur tangentialen Richtung, aufweisen.

Dies ermöglicht eine besonders effiziente und individuelle Reduktion von Wirbelströmen, welche auf den Ringstrukturen entstehen können, und deren Verteilung, insbesondere im Bereich der zumindest zwei Ringstrukturen und/oder der supraleitenden Spuleneinheit. Es können durch derartige Formen der Ringstrukturen auch die Zeitkonstanten der Wirbelströme auf den Ringstrukturen beeinflusst und optimiert werden.

Eine Ausführungsform der Magneteinheit sieht vor, dass die zumindest zwei Ringstrukturen in radialer Richtung an der dem Patientenaufnahmebereich zugewandten oder abgewandten Seite der Trägerstruktureinheit angeordnet sind. Eine Ringstruktur der zumindest zwei Ringstrukturen in radialer Richtung angeordnet an der dem Patientenaufnahmebereich zugewandten Seite kann als innere Ringstruktur bezeichnet werden. Eine Ringstruktur der zumindest zwei Ringstrukturen in radialer Richtung angeordnet an der dem Patientenaufnahmebereich abgewandten Seite kann als äußere Ringstruktur bezeichnet werden. Diese Ausführungsform sieht folglich vor, dass lediglich innere Ringstrukturen oder äußere Ringstrukturen vorhanden sind. Dies ermöglicht eine besonders kompakte Bauweise der passiven Abschirmeinheit.

Eine Ausführungsform der Magneteinheit sieht vor, dass die zumindest zwei Ringstrukturen zumindest vier Ringstrukturen umfassen, wobei zwei der zumindest vier Ringstrukturen als innere Ringstrukturen ausgebildet und in radialer Richtung an der dem Patientenaufnahmebereich zugewandten Seite der Trägerstruktureinheit angeordnet sind, und zwei der zumindest vier Ringstrukturen als äußere Ringstrukturen ausgebildet und in radialer Richtung an der dem Patientenaufnahmebereich abgewandten Seite der Trägerstruktureinheit angeordnet sind.

Gemäß dieser Ausführungsform umfasst die Magneteinheit demnach zumindest zwei innere Ringstrukturen und zumindest zwei äußere Ringstrukturen. Insbesondere können unterschiedliche Ringstrukturen verschiedene Arten von Wirbelfeldcharakteristiken adressieren. Beispielsweise können die in äußeren Ringstrukturen entstehenden Wirbelströme derart ausgestaltet sein, dass Wirbelfelder erster und/oder dritter Ordnung entstehen, welche auf anderen leitfähigen Strukturen entstehenden Wirbelfeldern erster und/oder dritter Ordnung entgegengerichtet sind und diese zumindest teilweise kompensieren. Beispielsweise können die in inneren Ringstrukturen entstehenden Wirbelströme derart ausgestaltet sein, dass Wirbelfelder vierter und/oder höherer Ordnung entstehen, welche auf anderen leitfähigen Strukturen entstehenden Wirbelfeldern vierter und/oder höherer Ordnung entgegengerichtet sind und diese zumindest teilweise kompensieren. Dies ermöglicht eine besonders effiziente Schirmung der supraleitenden Spuleneinheit.

Eine Ausführungsform der Magneteinheit sieht vor, dass sich die zumindest zwei Ringstrukturen, insbesondere die inneren Ringstrukturen von den äußeren Ringstrukturen, durch zumindest eine der folgenden Eigenschaften unterscheiden: Material, elektrische Leitfähigkeit, radiale Ausdehnung, Wanddicke, räumliche Ausdehnung in Längsrichtung, Mittelpunkte in Längsrichtung. Die Mittelpunkte in Längsrichtung definieren typischerweise die Position einer Ringstruktur in Längsrichtung. Die Wahl unterschiedlicher Materialien für verschiedene Ringstrukturen, die sich insbesondere in ihrer elektrischen Leitfähigkeit unterscheiden, ermöglicht eine besonders gute Anpassung an verschiedene Wirbelfeldcharakteristiken. Insbesondere können die inneren Ringstrukturen einheitlich ein erstes Material umfassen und die äußeren Ringstrukturen können einheitlich ein zweites Material umfassen. Dies vereinfacht die Herstellung der passiven Abschirmeinheit. Dennoch ermöglicht dies eine individuelle Wahl verschiedener elektrischer Leitfähigkeiten für die inneren Ringstrukturen und die äußeren Ringstrukturen.

Eine Ausführungsform der Magneteinheit sieht vor, dass die inneren Ringstrukturen und die äußeren Ringstrukturen in Längsrichtung zumindest teilweise alternierend angeordnet sind. Eine derartige passive Abschirmeinheit kann besonders robust hergestellt werden.

Eine Ausführungsform der Magneteinheit sieht vor, dass sich eine innere Ringstruktur und eine äußere Ringstruktur in Längsrichtung zumindest teilweise überlappen. Die Überlappung von zwei der zumindest vier Ringstrukturen ermöglicht eine Versteifung der passiven Abschirmeinheit, welche dadurch weniger anfällig für Vibrationen und/oder Schwingungen ist.

Eine Ausführungsform der Magneteinheit sieht vor, dass die supraleitende Spuleneinheit zumindest zwei Magnetspulen umfasst, wobei eine erste Magnetspule der zumindest zwei Magnetspulen und eine erste Ringstruktur der zumindest zwei Ringstrukturen an einer ersten Position in Längsrichtung und eine zweite Magnetspule der zumindest zwei Magnetspulen und eine zweite Ringstruktur der zumindest zwei Ringstrukturen an einer zweiten Position in Längsrichtung angeordnet sind.

Die erste Position ist typischerweise von der zweiten Position verschieden. Gemäß dieser Ausführungsform überlappen sich die erste Ringstruktur und die erste Magnetspule in Längsrichtung zumindest teilweise. Gemäß dieser Ausführungsform überlappen sich die zweite Ringstruktur und die zweite Magnetspule in Längsrichtung zumindest teilweise. Die zweite Ringstruktur ist demnach gut zur Abschirmung der zweiten Magnetspule durch von einer Gradientenspuleneinheit erzeugte Wirbelströme und/oder Streufelder ausgebildet. Die erste Ringstruktur ist demnach gut zur Abschirmung der ersten Magnetspule durch von einer Gradientenspuleneinheit erzeugte Wirbelströme und/oder Streufelder ausgebildet.

Eine Ausführungsform der Magneteinheit sieht vor, dass die passive Abschirmeinheit innerhalb des hohlzylindrischen Vakuumbehälters angeordnet ist. Die zumindest zwei Ringstrukturen sind vorzugsweise einer Temperatur zwischen 4 K und 100 K, besonders bevorzugt zwischen 30 K und 80 K ausgesetzt. Typischerweise ist die Leitfähigkeit der zumindest zwei Ringstrukturen bei derartigen Temperaturen höher als bei Raumtemperatur, wodurch die Ohm'schen Verluste reduziert werden und die Effizienz der zumindest zwei Ringstrukturen verbessert wird. Hierfür kann die Magneteinheit eine Kühlungseinheit umfassen, welche Kühlungseinheit an zumindest einer der zumindest zwei Ringstrukturen angeordnet ist.

Eine Ausführungsform der Magneteinheit sieht vor, dass die passive Abschirmeinheit außerhalb des Vakuumbehälters an dessen zum Patientenaufnahmebereich zugewandter Seite angeordnet ist. Dies ermöglicht eine besonders einfache Fertigung und Installation der passiven Abschirmeinheit. Insbesondere kann bei Bedarf die geometrische Anordnung der zumindest zwei Ringstrukturen geändert werden, wodurch die Abschirmung der supraleitenden Spuleneinheit verbessert werden kann.

Eine Ausführungsform der Magneteinheit sieht vor, dass die zumindest zwei Ringstrukturen punktsymmetrisch zu einem Isozentrum des Patientenaufnahmebereiches sind.

Eine Ausführungsform der Magneteinheit sieht vor, dass die zumindest zwei Ringstrukturen zumindest eines der folgenden Materialien umfasst: Aluminium, Aluminium mit einer Reinheit von zumindest 99%, Kupfer. Derartige Materialien sind besonders gut zu verarbeiten und weisen eine besonders hohe Leitfähigkeit auf.

Des Weiteren geht die Erfindung aus von einem Magnetresonanzgerät gemäß Anspruch 14 umfassend eine Magneteinheit nach einem der vorangehenden Ansprüche und eine hohlzylinderförmige Gradientenspuleneinheit, ausgebildet zur Erzeugung eines Magnetfeldgradienten durch Ansteuerung zumindest einer Primärspule frei von aktiver Schirmung, wobei die Gradientenspuleneinheit innerhalb der Magneteinheit angeordnet ist und den Patientenaufnahmebereich umgibt.

Die Vorteile des erfindungsgemäßen Magnetresonanzgeräts entsprechen im Wesentlichen den Vorteilen der erfindungsgemäßen Magneteinheit, welche vorab im Detail ausgeführt sind. Hierbei erwähnte Merkmale, Vorteile oder alternative Ausführungsformen können ebenso auch auf die anderen beanspruchten Gegenstände übertragen werden und umgekehrt.

Weitere Vorteile, Merkmale und Einzelheiten der Erfindung ergeben sich aus den im Folgenden beschriebenen Ausführungsbeispielen sowie anhand der Zeichnungen.

Es zeigen:
- Fig. 1: ein erfindungsgemäßes Magnetresonanzgerät in einer schematischen Darstellung,
- Fig. 2: eine erste Ausführungsform einer passiven Abschirmeinheit einer erfindungsgemäßen Magneteinheit in einer ersten Ansicht,
- Fig. 3: eine zweite Ausführungsform einer passiven Abschirmeinheit einer erfindungsgemäßen Magneteinheit in einer ersten Ansicht,
- Fig. 4: eine dritte Ausführungsform einer passiven Abschirmeinheit einer erfindungsgemäßen Magneteinheit in einer ersten Ansicht,
- Fig. 5: eine vierte Ausführungsform einer passiven Abschirmeinheit einer erfindungsgemäßen Magneteinheit in einer ersten Ansicht,
- Fig. 6: eine fünfte Ausführungsform einer passiven Abschirmeinheit einer erfindungsgemäßen Magneteinheit in einer ersten Ansicht,
- Fig. 7: eine sechste Ausführungsform einer passiven Abschirmeinheit einer erfindungsgemäßen Magneteinheit in einer ersten Ansicht,
- Fig. 8: eine siebte Ausführungsform einer passiven Abschirmeinheit einer erfindungsgemäßen Magneteinheit in einer ersten Ansicht,
- Fig. 9: eine achte Ausführungsform einer passiven Abschirmeinheit einer erfindungsgemäßen Magneteinheit in einer ersten Ansicht,
- Fig. 10: eine neunte Ausführungsform einer passiven Abschirmeinheit einer erfindungsgemäßen Magneteinheit in einer ersten Ansicht,
- Fig. 11: eine zehnte Ausführungsform einer passiven Abschirmeinheit einer erfindungsgemäßen Magneteinheit in einer zweiten Ansicht,
- Fig. 12: eine elfte Ausführungsform einer passiven Abschirmeinheit einer erfindungsgemäßen Magneteinheit in einer zweiten Ansicht, und
- Fig. 13: eine schematische Darstellung eines Zylinders zur Erläuterung von Parametern.

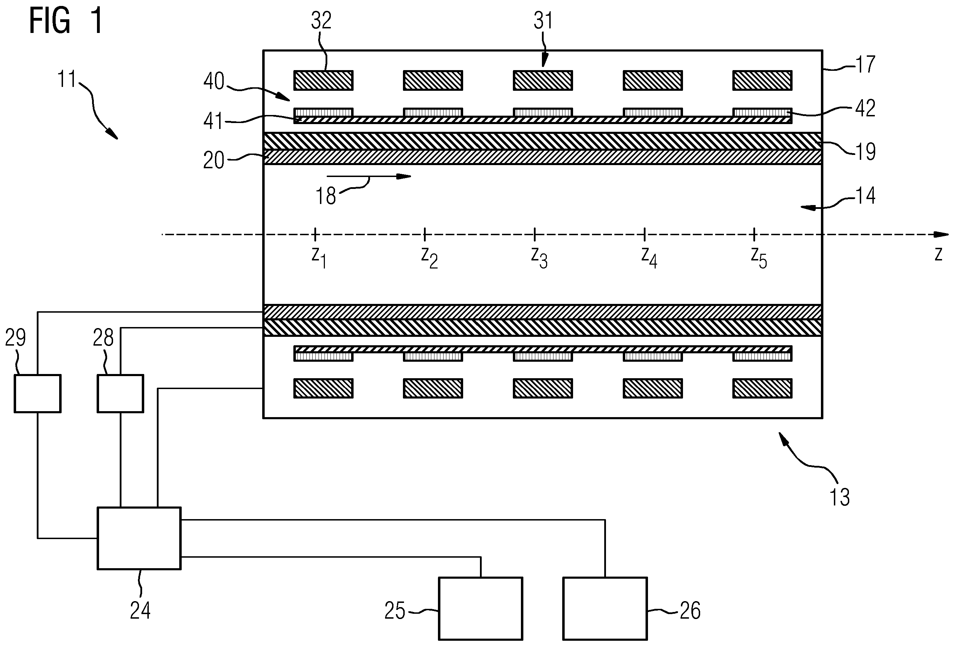

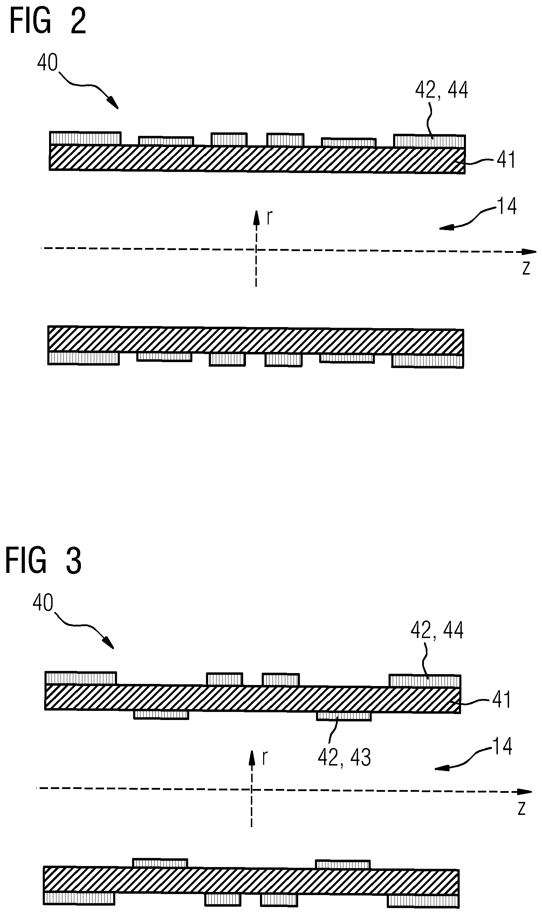

Das in der Figur 1 gezeigte Magnetresonanzgerät, sowie die in den Figuren 2-11 gezeigten Ausführungsformen einer passiven Abschirmeinheit sind nur dann erfindungsgemäß, wenn die räumliche Ausdehnung in Längsrichtung und/oder in radialer Richtung zumindest einer Ringstruktur der zumindest zwei Ringstrukturen in Umfangsrichtung variiert, wie es in Anspruch 1 definiert wird.

Figur 1 zeigt ein erfindungsgemäßes Magnetresonanzgerät 11 umfassend eine Detektoreinheit umfassend eine erfindungsgemäße Magneteinheit 13, eine Gradientenspuleneinheit 19 und eine Hochfrequenzantenneneinheit 20 in einer schematischen Darstellung. Die Detektoreinheit ist typischerweise hohlzylinderförmig ausgestaltet. Zudem weist das Magnetresonanzgerät 11 einen zylinderförmigen Patientenaufnahmebereich 14 auf, wobei der Patientenaufnahmebereich 14 in einer Umfangsrichtung der Detektoreinheit von der Detektoreinheit zylinderförmig umschlossen ist. Ein Patient kann mittels einer Patientenlagerungsvorrichtung in den Patientenaufnahmebereich 14 geschoben werden. Die Zylinderachse z des Patientenaufnahmebereichs 14 in Längsrichtung entspricht der Zylinderachse z der Detektoreinheit, insbesondere auch der Zylinderachse z der Magneteinheit 13, der Gradientenspuleneinheit 19 und der Hochfrequenzantenneneinheit 20 in Längsrichtung.

Die Magneteinheit 13 umfasst einen hohlzylindrischen Vakuumbehälter 17 umgebend den zylindrischen Patientenaufnahmebereich 14. Innerhalb des hohlzylindrischen Vakuumbehälters 17 ist eine supraleitende Spuleneinheit 31 angeordnet, welche zu einem Erzeugen eines starken und insbesondere konstanten und statischen Hauptmagnetfelds 18 ausgebildet ist. Zudem umfasst die Magneteinheit 13 eine passive Abschirmeinheit 40 umfassend eine Trägerstruktureinheit 41, und Ringstrukturen 42, welche hohlzylinderförmig ausgebildet sind. Die Ringstrukturen 42 weisen senkrecht zur radialen Richtung, insbesondere tangential und/oder in Umfangsrichtung, flächigen Kontakt zu der Trägerstruktureinheit auf und sind in Längsrichtung zueinander beabstandet und an den Positionen z₁, z₂, z₃, z₄, z₅ in Längsrichtung angeordnet. Die supraleitende Spuleneinheit 31 umfasst zumindest zwei, im dargestellten Fall fünf, Magnetspulen 32, die ebenso an den Positionen z₁, z₂, z₃, z₄, z₅ in Längsrichtung angeordnet sind. Die passive Abschirmeinheit 40 ist im dargestellten Fall innerhalb des hohlzylindrischen Vakuumbehälters 17 angeordnet.

Die Gradientenspuleneinheit 19 umfasst zumindest eine Primärspule ausgebildet zur Erzeugung eines Magnetfeldgradienten zur Verwendung für eine Ortskodierung während einer Bildgebung und ist frei von einer aktiven Schirmung, insbesondere frei von einer Sekundärspule, insbesondere frei von einer aktiv angesteuerten Sekundärspule. Die Gradientenspuleneinheit 19 ist hohlzylinderförmig ausgestaltet und zwischen Magneteinheit 13 und Patientenaufnahmebereich 14 angeordnet. Die Gradientenspuleneinheit 19 wird mittels einer Gradientensteuereinheit 28 angesteuert.

Des Weiteren weist das Magnetresonanzgerät 11 eine Hochfrequenzantenneneinheit 20, welche im gezeigten Fall als fest in das Magnetresonanzgerät 11 integrierte Körperspule ausgebildet ist, und eine Hochfrequenzantennensteuereinheit 29 zu einer Anregung einer Polarisation, die sich in dem von der Magneteinheit 13 erzeugten Hauptmagnetfeld 18 einstellt, auf. Die Hochfrequenzantenneneinheit 20 wird von der Hochfrequenzantennensteuereinheit 29 angesteuert und strahlt hochfrequente Hochfrequenz-Pulse in einen Untersuchungsraum, der im Wesentlichen von dem Patientenaufnahmebereich 14 gebildet ist, ein.

Zu einer Steuerung der Magneteinheit 13, der Gradientensteuereinheit 28 und der Hochfrequenzantennensteuereinheit 29 weist das Magnetresonanzgerät 11 eine Steuerungseinheit 24 auf. Die Steuerungseinheit 24 steuert zentral das Magnetresonanzgerät 11, wie beispielsweise das Durchführen von MR-Steuerungssequenzen. Zudem umfasst die Steuerungseinheit 24 eine nicht näher dargestellte Rekonstruktionseinheit zu einer Rekonstruktion von medizinischen Bilddaten, die während der Magnetresonanzuntersuchung erfasst werden. Das Magnetresonanzgerät 11 weist eine Anzeigeeinheit 25 auf. Steuerinformationen wie beispielsweise Steuerungsparameter, sowie rekonstruierte Bilddaten können auf der Anzeigeeinheit 25, beispielsweise auf zumindest einem Monitor, für einen Benutzer angezeigt werden. Zudem weist das Magnetresonanzgerät 11 eine Eingabeeinheit 26 auf, mittels derer Informationen und/oder Steuerungsparameter während eines Messvorgangs von einem Benutzer eingegeben werden können. Die Steuerungseinheit 24 kann die Gradientensteuereinheit 28 und/oder Hochfrequenzantennensteuereinheit 29 und/oder die Anzeigeeinheit 25 und/oder die Eingabeeinheit 26 umfassen.

Das dargestellte Magnetresonanzgerät 11 kann selbstverständlich weitere Komponenten umfassen, die Magnetresonanzgeräte 11 gewöhnlich aufweisen. Eine allgemeine Funktionsweise eines Magnetresonanzgeräts 11 ist zudem dem Fachmann bekannt, so dass auf eine detaillierte Beschreibung der weiteren Komponenten verzichtet wird.

Figur 2 zeigt eine erste Ausführungsform einer passiven Abschirmeinheit 40 einer erfindungsgemäßen Magneteinheit 13 in einer ersten Ansicht, wobei die Ringstrukturen 42 in radialer Richtung r an der dem Patientenaufnahmebereich 14 abgewandten Seite der Trägerstruktureinheit 41, angeordnet sind und somit als äußere Ringstrukturen 44 ausgebildet sind. Die räumliche Ausdehnung in Längsrichtung z der Trägerstruktureinheit 14 ist zumindest viermal so groß wie die räumliche Ausdehnung in Längsrichtung z einer Ringstruktur 42. Die Trägerstruktureinheit 41 ist als massiver Hohlzylinder ausgebildet. Die Ringstrukturen 42, 44 unterscheiden sich in ihrer räumlichen Ausdehnung in radialer Richtung r und in Längsrichtung z voneinander.

Zudem sind die Ringstrukturen 42, 44 punktsymmetrisch zu einem Isozentrum des Patientenaufnahmebereiches 14, welches im dargestellten Fall durch den Schnittpunkt der Längsachse z mit der Markierung der radialen Richtung r definiert sein kann.

Figur 3 zeigt eine zweite Ausführungsform einer passiven Abschirmeinheit 40 einer erfindungsgemäßen Magneteinheit 13 in einer ersten Ansicht. Diese unterscheidet sich von der ersten Ausführungsform darin, dass die passive Abschirmeinheit 40 sechs Ringstrukturen 42 umfasst, wovon zwei in radialer Richtung r an der dem Patientenaufnahmebereich 14 zugewandten Seite der Trägerstruktureinheit 41 angeordnet sind und als innere Ringstrukturen 43 ausgebildet sind, und wovon vier in radialer Richtung r an der dem Patientenaufnahmebereich 14 abgewandten Seite der Trägerstruktureinheit 41 angeordnet sind und als äußere Ringstrukturen 44 ausgebildet sind. Die inneren Ringstrukturen 43 und äußeren Ringstrukturen 44 sind in Längsrichtung z zumindest teilweise alternierend angeordnet. In Längsrichtung z unterscheiden sich die Positionen, insbesondere die Mittelpunkte der inneren Ringstrukturen 43 und der äußeren Ringstrukturen 44 jeweils voneinander.

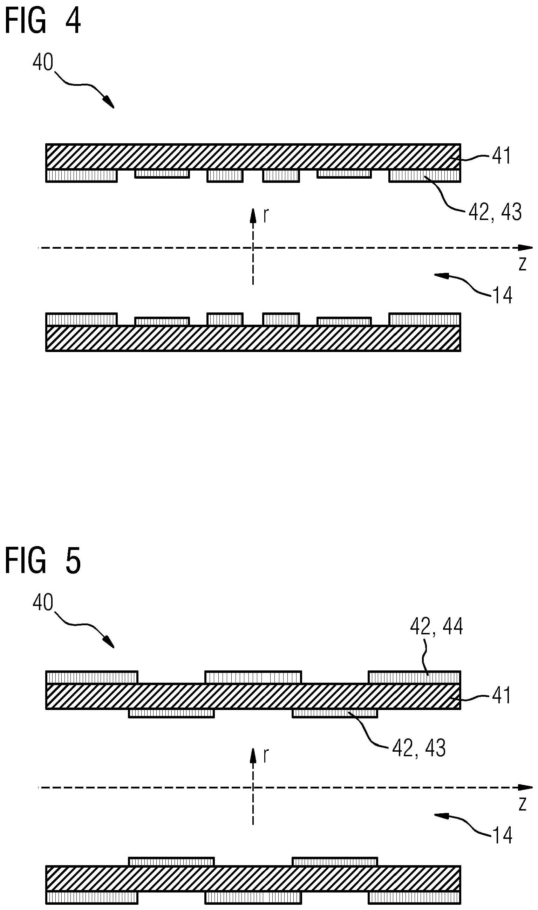

Figur 4 zeigt eine dritte Ausführungsform einer passiven Abschirmeinheit 40 einer erfindungsgemäßen Magneteinheit 13 in einer ersten Ansicht. Diese unterscheidet sich von der ersten Ausführungsform darin, dass die Ringstrukturen 42, 43 in radialer Richtung r an der dem Patientenaufnahmebereich 14 zugewandten Seite der Trägerstruktureinheit 41 angeordnet sind und somit als innere Ringstrukturen 43 ausgebildet sind.

Figur 5 zeigt eine vierte Ausführungsform einer passiven Abschirmeinheit 40 einer erfindungsgemäßen Magneteinheit 13 in einer ersten Ansicht. Diese unterscheidet sich von der zweiten Ausführungsform darin, dass sich die inneren Ringstrukturen 43 und die äußeren Ringstrukturen 44 in Längsrichtung z zumindest teilweise überlappen.

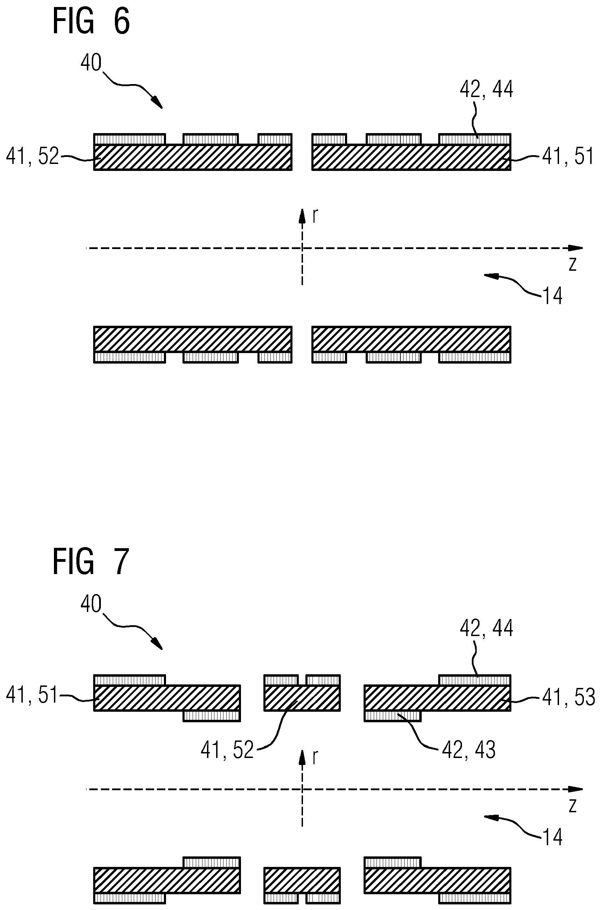

Figur 6 zeigt eine fünfte Ausführungsform einer passiven Abschirmeinheit 40 einer erfindungsgemäßen Magneteinheit 13 in einer ersten Ansicht. Diese unterscheidet sich von der ersten Ausführungsform darin, dass die Trägerstruktureinheit 41 zwei in Längsrichtung z zueinander beabstandete Hohlzylinder 51, 52 angeordnet um die Zylinderachse, insbesondere die Längsrichtung z, umfasst.

Figur 7 zeigt eine sechste Ausführungsform einer passiven Abschirmeinheit 40 einer erfindungsgemäßen Magneteinheit 13 in einer ersten Ansicht. Diese unterscheidet sich von der zweiten Ausführungsform darin, dass die Trägerstruktureinheit 41 drei in Längsrichtung z zueinander beabstandete Hohlzylinder 51, 52, 53 angeordnet um die Zylinderachse, insbesondere die Längsrichtung z, umfasst.

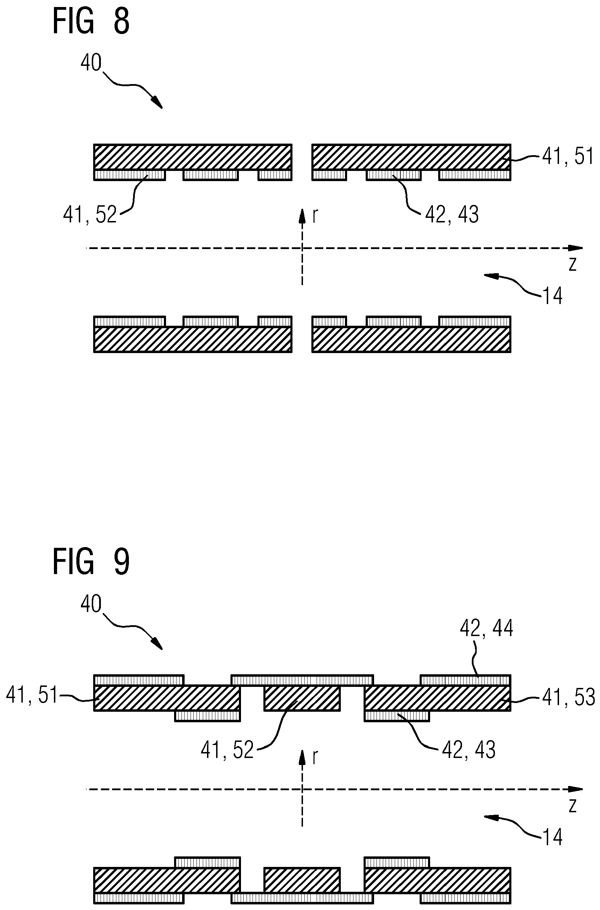

Figur 8 zeigt eine siebte Ausführungsform einer passiven Abschirmeinheit 40 einer erfindungsgemäßen Magneteinheit 13 in einer ersten Ansicht. Diese unterscheidet sich von der dritten Ausführungsform darin, dass die Trägerstruktureinheit 41 zwei in Längsrichtung z zueinander beabstandete Hohlzylinder 51, 52 angeordnet um die Zylinderachse, insbesondere die Längsrichtung z, umfasst.

Figur 9 zeigt eine achte Ausführungsform einer passiven Abschirmeinheit 40 einer erfindungsgemäßen Magneteinheit 13 in einer ersten Ansicht. Diese unterscheidet sich von der sechsten Ausführungsform darin, dass sich die inneren Ringstrukturen 43 und die äußeren Ringstrukturen 44 in Längsrichtung z zumindest teilweise überlappen.

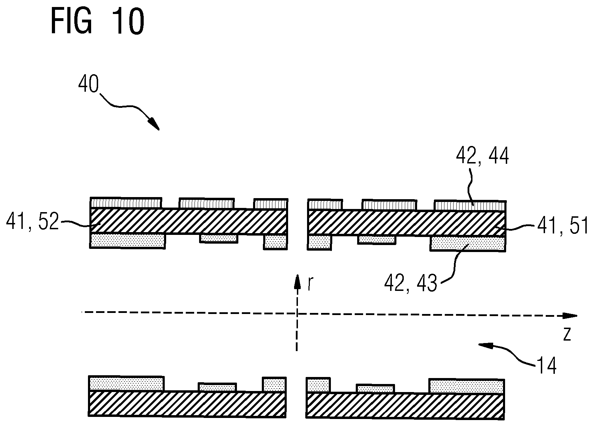

Figur 10 zeigt eine neunte Ausführungsform einer passiven Abschirmeinheit 40 einer erfindungsgemäßen Magneteinheit 13 in einer ersten Ansicht, welche innere Ringstrukturen 43 und äußere Ringstrukturen 44 aufweisen, welche sich durch die folgenden Eigenschaften unterscheiden: Material, elektrische Leitfähigkeit, räumliche Ausdehnung in radialer Richtung r, räumliche Ausdehnung in Längsrichtung z und zumindest teilweise deren Mittelpunkte in Längsrichtung z.

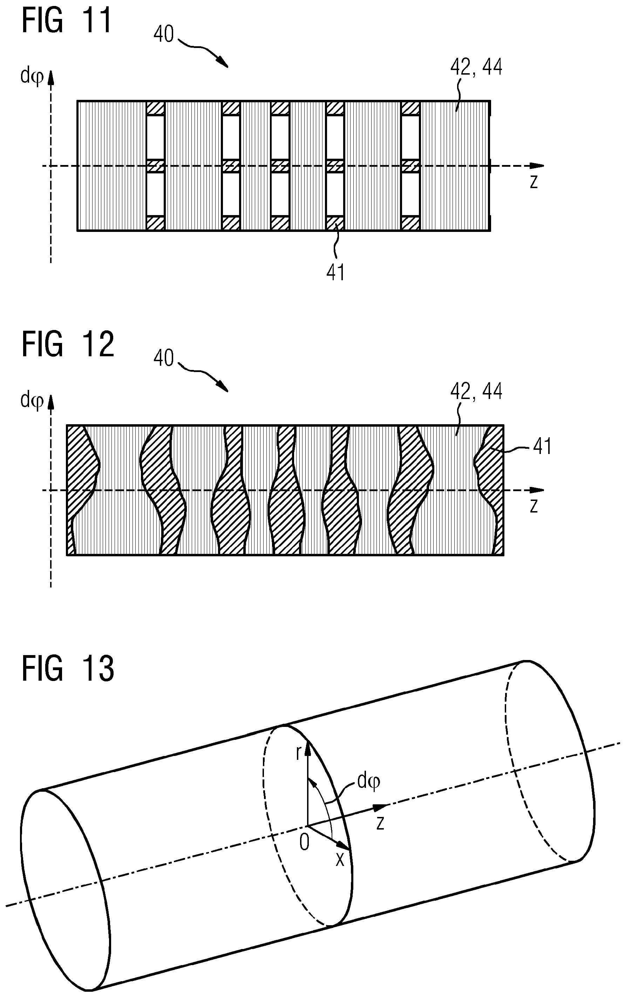

Figur 11 zeigt eine zehnte Ausführungsform einer passiven Abschirmeinheit 40 einer erfindungsgemäßen Magneteinheit 13 in einer zweiten Ansicht. Diese Ausführungsform sieht vor, dass die Trägerstruktureinheit 41 als Gerüststruktur ausgebildet ist.

Figur 12 zeigt eine elfte Ausführungsform einer passiven Abschirmeinheit 40 einer erfindungsgemäßen Magneteinheit 13 in einer zweiten Ansicht. wie die Erfindung generell, sieht diese Ausführungsform vor, dass die räumliche Ausdehnung in Längsrichtung z und/oder in radialer Richtung r einer Ringstruktur 42 in Umfangsrichtung variiert.

Figur 13 zeigt eine schematische Darstellung eines Zylinders zur Erläuterung von Parametern. Die Zylinderachse entspricht der Längsrichtung z, insbesondere der Längsrichtung z der Magneteinheit 13. Die Umfangrichtung kann durch dφ charakterisiert werden. Die Richtung senkrecht zur Umfangrichtung dφ wird als radiale Richtung r bezeichnet. Die mit x bezeichnete Richtung ist typischerweise senkrecht zur Längsrichtung z und horizontal ausgerichtet.

Obwohl die Erfindung im Detail durch die bevorzugten Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den durch die Ansprüche definierten Schutzumfang der Erfindung zu verlassen.

## Patentansprüche

1. Magneteinheit (13) ausgebildet zur Verwendung in einem Magnetresonanzgerät (11) umfassend einen hohlzylindrischen Vakuumbehälter (17) umgebend einen zylindrischen Patientenaufnahmebereich (14) entlang einer Zylinderachse (z) in Längsrichtung, eine supraleitende Spuleneinheit (31) ausgebildet zur Erzeugung eines statischen Hauptmagnetfeldes (18) und angeordnet innerhalb des hohlzylindrischen Vakuumbehälters, und eine passive Abschirmeinheit (40) zur Abschirmung von Streufeldern und/oder Wirbelströmen, die von einer Gradientenspuleneinheit (19) erzeugt werden, wobei die passive Abschirmeinheit eine Trägerstruktureinheit (41), welche hohlzylinderförmig den Patientenaufnahmebereich umgibt, und zumindest zwei Ringstrukturen (42, 43, 44) umfasst, welche hohlzylinderförmig ausgebildet sind, wobei die zumindest zwei Ringstrukturen senkrecht zur radialen Richtung (r) flächigen Kontakt zu der Trägerstruktureinheit aufweisen, wobei zwei der zumindest zwei Ringstrukturen in Längsrichtung zueinander beabstandet sind, **dadurch gekennzeichnet, dass** die räumliche Ausdehnung in Längsrichtung und/oder in radialer Richtung zumindest einer Ringstruktur der zumindest zwei Ringstrukturen in Umfangsrichtung variiert.

2. Magneteinheit nach Anspruch 1,
wobei die räumliche Ausdehnung in Längsrichtung der Trägerstruktureinheit zumindest viermal so groß wie die räumliche Ausdehnung in Längsrichtung einer Ringstruktur der zumindest zwei Ringstrukturen ist.

3. Magneteinheit nach einem der vorangehenden Ansprüche,
wobei die zumindest zwei Ringstrukturen eine elektrische Leitfähigkeit von zumindest 2 x 10⁷ S/m aufweisen und die Trägerstruktureinheit eine elektrische Leitfähigkeit von weniger als 10⁵ S/m aufweist.

4. Magneteinheit nach einem der vorangehenden Ansprüche,
wobei die Trägerstruktureinheit zumindest eines der folgenden Materialien umfasst: Faser-Kunststoff-Verbund, glasfaserverstärkter Kunststoff, kohlenstofffaserverstärkter Kunststoff.

5. Magneteinheit nach einem der vorangehenden Ansprüche,
wobei die Trägerstruktureinheit als Gerüststruktur oder als massiver Hohlzylinder ausgebildet ist.

6. Magneteinheit nach einem der vorangehenden Ansprüche,
wobei die Trägerstruktureinheit zumindest zwei in Längsrichtung beabstandete Hohlzylinder angeordnet um die Zylinderachse umfasst.

7. Magneteinheit nach einem der vorangehenden Ansprüche,
wobei sich die zumindest zwei Ringstrukturen durch zumindest eine der folgenden Eigenschaften unterscheiden: Material, elektrische Leitfähigkeit, Mittelpunkte in Längsrichtung, Wanddicke, räumliche Ausdehnung in Längsrichtung.

8. Magneteinheit nach einem der vorangehenden Ansprüche,
wobei die zumindest zwei Ringstrukturen in radialer Richtung an der dem Patientenaufnahmebereich zugewandten oder abgewandten Seite der Trägerstruktureinheit angeordnet sind.

9. Magneteinheit nach einem der vorangehenden Ansprüche,
wobei die zumindest zwei Ringstrukturen zumindest vier Ringstrukturen umfassen,
wobei zwei der zumindest vier Ringstrukturen als innere Ringstrukturen ausgebildet und in radialer Richtung an der dem Patientenaufnahmebereich zugewandten Seite der Trägerstruktureinheit angeordnet sind, und zwei der zumindest vier Ringstrukturen als äußere Ringstrukturen ausgebildet und in radialer Richtung an der dem Patientenaufnahmebereich abgewandten Seite der Trägerstruktureinheit angeordnet sind.

10. Magneteinheit nach Anspruch 9,
wobei die inneren Ringstrukturen und die äußeren Ringstrukturen in Längsrichtung zumindest teilweise alternierend angeordnet sind.

11. Magneteinheit nach einem der Ansprüche 9 bis 10,
wobei sich eine innere Ringstruktur und eine äußere Ringstruktur in Längsrichtung zumindest teilweise überlappen.

12. Magneteinheit nach einem der vorangehenden Ansprüche,
wobei die supraleitende Spuleneinheit zumindest zwei Magnetspulen (32) umfasst, wobei eine erste Magnetspule der zumindest zwei Magnetspulen und eine erste Ringstruktur der zumindest zwei Ringstrukturen an einer ersten Position in Längsrichtung und eine zweite Magnetspule der zumindest zwei Magnetspulen und eine zweite Ringstruktur der zumindest zwei Ringstrukturen an einer zweiten Position in Längsrichtung angeordnet sind.

13. Magneteinheit nach einem der vorangehenden Ansprüche,
wobei die passive Abschirmeinheit innerhalb des hohlzylindrischen Vakuumbehälters angeordnet ist.

14. Magnetresonanzgerät (11) umfassend eine Magneteinheit (13) nach einem der vorangehenden Ansprüche und eine hohlzylinderförmige Gradientenspuleneinheit (19), ausgebildet zur Erzeugung eines Magnetfeldgradienten durch Ansteuerung zumindest einer Primärspule frei von aktiver Schirmung, wobei die Gradientenspuleneinheit innerhalb der Magneteinheit angeordnet ist und den Patientenaufnahmebereich umgibt.

## Claims

1. Magnet unit (13) designed for use in a magnetic resonance device (11) comprising
a hollow cylindrical vacuum container (17) surrounding a cylindrical patient receiving region (14) in a longitudinal direction along a cylindrical axis (z),
a superconducting coil unit (31) designed for generating a static main magnetic field (18) and arranged within the hollow cylindrical vacuum container,
and a passive shielding unit (40) for shielding from stray fields and/or eddy currents which are generated by a gradient coil unit (19), wherein the passive shielding unit comprises a support structure unit (41) which surrounds the patient receiving region in the form of a hollow cylinder and comprises at least two annular structures (42, 43, 44) designed as hollow cylinders,
wherein the at least two annular structures make surface contact that is perpendicular to the radial direction (r) with the support structure unit,
wherein two of the at least two annular structures are at a distance from one another in the longitudinal direction, **characterised in that** the spatial extent of at least one annular structure of the at least two annular structures in the longitudinal direction and/or in the radial direction varies in the circumferential direction.

2. Magnet unit according to claim 1,
wherein the spatial extent of the support structure unit in the longitudinal direction is at least four times as great as the spatial extent of an annular structure of the at least two annular structures in the longitudinal direction.

3. Magnet unit according to one of the preceding claims,
wherein the at least two annular structures have an electrical conductivity of at least 2 x 10⁷ S/m and the support structure unit has an electrical conductivity of less than 10⁵ S/m.

4. Magnet unit according to one of the preceding claims,
wherein the support structure unit comprises at least one of the following materials: fibre-plastic composite, glass fibre-reinforced plastic, carbon fibre-reinforced plastic.

5. Magnet unit according to one of the preceding claims,
wherein the support structure unit is designed as a gantry structure or as a solid hollow cylinder.

6. Magnet unit according to one of the preceding claims,
wherein the support structure unit comprises at least two hollow cylinders arranged about the cylindrical axis at a distance from one another in the longitudinal direction.

7. Magnet unit according to one of the preceding claims,
wherein the at least two annular structures differ from one another in terms of at least one of the following properties: material, electrical conductivity, centre points in the longitudinal direction, wall thickness, spatial extent in the longitudinal direction.

8. Magnet unit according to one of the preceding claims,
wherein the at least two annular structures are arranged in the radial direction on the side of the support structure unit facing the patient receiving region or facing away from the patient receiving region.

9. Magnet unit according to one of the preceding claims,
wherein the at least two annular structures comprise at least four annular structures,
wherein two of the at least four annular structures are designed as inner annular structures and are arranged in the radial direction on the side of the support structure unit facing the patient receiving region and two of the at least four annular structures are designed as outer annular structures and are arranged in the radial direction on the side of the support structure unit facing away from the patient receiving region.

10. Magnet unit according to claim 9,
wherein the inner annular structures and the outer annular structures are arranged in the longitudinal direction in an at least partially alternating manner.

11. Magnet unit according to one of claims 9 or 10,
wherein one inner annular structure and one outer annular structure at least partially overlap in the longitudinal direction.

12. Magnet unit according to one of the preceding claims,
wherein the superconducting coil unit comprises at least two magnet coils (32), wherein a first magnet coil of the at least two magnet coils and a first annular structure of the at least two annular structures are arranged at a first position in the longitudinal direction and a second magnet coil of the at least two magnet coils and a second annular structure of the at least two annular structures are arranged at a second position in the longitudinal direction.

13. Magnet unit according to one of the preceding claims,
wherein the passive shielding unit is arranged within the hollow cylindrical vacuum container.

14. Magnetic resonance device (11) comprising a magnet unit (13) according to one of the preceding claims and a gradient coil unit (19) in the form of a hollow cylinder designed for generating a magnetic field gradient by actuating at least one primary coil free of active shielding, wherein the gradient coil unit is arranged within the magnet unit and surrounds the patient receiving region.

## Revendications

1. Unité (13) magnétique destinée à être utilisée dans un appareil (11) de résonnance magnétique comprenant un récipient (17) sous vide cylindrique creux entourant une zone (14) cylindrique de réception d'un patient le long d'un axe (z) de cylindre dans la direction longitudinale, une unité (31) de bobine supraconductrice constituée pour la production d'un champ (18) magnétique principal statique et disposée à l'intérieur du récipient sous vide cylindrique creux, et une unité (40) de blindage passif pour la protection vis-à-vis de champs de dispersion et/ou de courants de Foucault, qui sont produits par une unité (19) de bobine de gradient, dans laquelle l'unité de blindage passive comprend une unité (41) de structure de support, qui entoure, en forme de cylindre creux, la zone de réception de patient, et au moins deux structures (42, 43, 44) annulaires, qui sont constituées en forme de cylindre creux,
dans laquelle les au moins deux structures annulaires ont, perpendiculairement à la direction (r) radiale, un contact plat avec l'unité de structure de support,
dans laquelle
deux des au moins deux structures annulaires sont à distance l'une de l'autre dans la direction longitudinale, **caractérisée en ce que** l'étendue dans l'espace, dans la direction longitudinale et/ou dans la direction radiale d'au moins une structure annulaire des au moins deux structures annulaires varie dans la direction périphérique.

2. Unité magnétique suivant la revendication 1,
dans laquelle l'étendue dans l'espace dans la direction longitudinale de l'unité de structure de support est au moins quatre fois aussi grande que l'étendue dans l'espace dans la direction longitudinale d'une structure annulaire des au moins deux structures annulaires.

3. Unité magnétique suivant l'une des revendications précédentes,
dans laquelle les au moins deux structures annulaires ont une conductivité électrique d'au moins 2 x 10⁷ S/m et l'unité de structure de support a une conductivité électrique de moins de 10⁵ S/m.

4. Unité magnétique suivant l'une des revendications précédentes,
dans laquelle l'unité de structure de support comprend au moins l'un des matériaux suivants : composite fibre-matière plastique, matière plastique renforcée par de la fibre de verre, matière plastique renforcée par de la fibre de carbone.

5. Unité magnétique suivant l'une des revendications précédentes,
dans laquelle l'unité de structure de support est constituée sous la forme d'une structure en ossature ou sous la forme d'un cylindre creux massif.

6. Unité magnétique suivant l'une des revendications précédentes,
dans laquelle l'unité de structure de support comprend au moins deux cylindres creux à distance dans la direction périphérique, disposés autour de l'axe du cylindre.

7. Unité magnétique suivant l'une des revendications précédentes,
dans laquelle les au moins deux structures annulaires se distinguent par au moins l'une des propriétés suivantes : matériau, conductivité électrique, point médian dans la direction longitudinale, épaisseur de paroi, étendue dans l'espace dans la direction longitudinale.

8. Unité magnétique suivant l'une des revendications précédentes,
dans laquelle les au moins deux structures annulaires sont disposées dans la direction radiale sur la face de l'unité de structure de support, tournée vers la zone de réception de patient ou non tournée vers celle-ci.

9. Unité magnétique suivant l'une des revendications précédentes,
dans laquelle les au moins deux structures annulaires comprennent au moins quatre structures annulaires,
dans laquelle deux des au moins quatre structures annulaires sont constituées sous la forme de structures annulaires intérieures et sont disposées dans la direction radiale sur la face, tournée vers la zone de réception du patient, de l'unité de structure de support et deux des au moins quatre structures annulaires sont constituées sous la forme de structures annulaires extérieures et sont disposées dans la direction radiale sur la face, non tournée vers la zone de réception du patient, de l'unité de structure de support.

10. Unité magnétique suivant la revendication 9,
dans laquelle les structures annulaires intérieures et les structures annulaires extérieures sont disposées dans la direction longitudinale en alternance au moins en partie.

11. Unité magnétique suivant l'une des revendications 9 à 10,
dans laquelle une structure annulaire intérieure et une structure annulaire extérieure se chevauchent au moins en partie dans la direction longitudinale.

12. Unité magnétique suivant l'une des revendications précédentes,
dans laquelle l'unité de bobine supraconductrice comprend au moins deux bobines (32) magnétiques, dans laquelle une première bobine magnétique des au moins deux bobines magnétiques et une première structure annulaire des au moins deux structures annulaires sont disposées en une première position dans la direction longitudinale, et une deuxième bobine magnétique des au moins deux bobines magnétiques et une deuxième structure annulaire des au moins deux structures annulaires sont disposées en une deuxième position dans la direction longitudinale.

13. Unité magnétique suivant l'une des revendications précédentes,
dans laquelle l'unité de blindage passif est disposée à l'intérieur du récipient sous vide cylindrique creux.

14. Appareil (11) de résonnance magnétique comprenant une unité (13) magnétique suivant l'une des revendications précédentes et une unité (19) de bobine de gradient en forme de cylindre creux constituée pour la production d'un gradient de champ magnétique par commande d'au moins une bobine primaire sans blindage actif, dans laquelle l'unité de bobine de gradient est disposée à l'intérieur de l'unité magnétique et entoure la zone de réception d'un patient.
